# EUROPEAN PATENT APPLICATION

(11) **EP 4 810 652 A1**
(43) Date of publication of application: **23.09.2026**
(21) Application number: 24890628.1
(22) Date of filing: 11.11.2024
(51) Int. Cl.: C23C 16/458, C23C 16/509, C23C 16/46

(54) **COATING CARRIER PLATE AND COATING APPARATUS**

(30) Priority: 16.11.2023 CN 202323092604 U; 16.11.2023 CN 202323092686 U
(71) Applicant: Suzhou Maxwell Technologies Co., Ltd., Suzhou, Jiangsu 215200 (CN); Suzhou Maizheng Technology Co., Ltd, Suzhou, Jiangsu 215200 (CN)
(72) Inventor: LIU, Yanan, Suzhou, Jiangsu 215200 (CN); SUN, Jian, Suzhou, Jiangsu 215200 (CN); CHEN, Chen, Suzhou, Jiangsu 215200 (CN); ZHOU, Jian, Suzhou, Jiangsu 215200 (CN); WANG, Dengzhi, Suzhou, Jiangsu 215200 (CN)
(74) Representative: Balder IP Law, S.L.
(86) International application number: PCT/CN2024/131337
(87) International publication number: WO 2025/103273

(57) **Abstract**

This application discloses a film deposition carrier and a film deposition apparatus, belonging to the field of solar cells. A film deposition carrier is applied to a film deposition apparatus, which further includes a lifting heating plate. The film deposition carrier comprises a frame and a tray, with the tray being fixedly disposed on the frame. The frame includes a plurality of ribs arranged in a criss-cross pattern and conductive wrapping sheets, and a plurality of conductive wrapping sheets are disposed at the bottom of any one or more of the ribs. By disposing the conductive wrapping sheets, the present application achieves good contact between the carrier and the lifting heating plate, improves the electrical conductivity therebetween, enables high-power radio frequency current to be withstood, prolongs the service life of the equipment, and improves the quality of the film deposition products.

## Description

### TECHNICAL FIELD

This application belongs to the technical field of solar cells, relates to film deposition treatment, and specifically relates to a film deposition carrier and a film deposition apparatus.

### BACKGROUND

A plate-type or capacitively coupled plasma enhanced chemical vapor deposition (PECVD) vacuum film deposition line adopts a dynamic carrier transport and static film deposition mode. The film deposition production line generally consists of a loading chamber, a preheating chamber, a process chamber and an unloading chamber. The carrier is conveyed by rollers, passes through the loading chamber and the preheating chamber, and then stays in the process chamber. A power supply is fed in to generate plasma discharge for film deposition. A lifting heating plate and an upper electrode are disposed in the plate-type PECVD process chamber, wherein the upper electrode is a plate electrode, and the lifting heating plate serves as the lower electrode and is grounded. An upper electrode and a lower electrode are disposed in the capacitively coupled plasma-enhanced chemical vapor deposition process chamber, wherein the lower electrode forms a capacitively coupled discharge structure together with a lifting heating plate and a film deposition carrier.

The carrier is composed of a frame and a tray, and the carbon fiber frame and the tray are fixed together by screws and corner brackets. The silicon wafer is placed on the carrier, and the carrier is transported through the preheating chamber by rollers to heat the carrier and the silicon wafer. After reaching a predetermined temperature, the carrier enters the process chamber. After the carrier is transported to the process chamber, the lifting heating plate lifts the carrier to make the carrier separate from the conveyor rollers. The bottom of the carrier frame is in contact with the lifting heating plate and together serve as the lower electrode, forming a circuit with the upper electrode. After the radio frequency power is supplied, plasma glow discharge is generated between the upper and lower electrodes, and the process gas in the chamber is dissociated and deposited onto the silicon wafer to form a thin film.

However, during the heating and film deposition process, sufficient contact cannot be achieved between the bottom of the carbon fiber frame of the carrier and the surface of the lifting heating plate, resulting in gaps that seriously affect the electrical conductivity therebetween. Furthermore, when a high-power radio frequency power supply is supplied, the existence of gaps is likely to cause discharge between the carrier frame and the lifting heating plate. A large amount of heat generated instantaneously by the electric arc will damage the carbon fiber carrier and the lifting heating plate, reduce the service life thereof and the lifting heating plate, and also adversely affect the quality of the film deposition products. Therefore, improving the electrical conductivity between the carrier and the lifting heating plate has become an urgent problem to be solved.

### SUMMARY

This present application aims to solve at least one of the technical problems in the above-mentioned related art to a some extent.

To this end, the purpose of the present application is to provide a film deposition carrier and a film deposition apparatus. By providing conductive wrapping sheets, good contact between the carrier and the lifting heating plate is achieved, the electrical conductivity therebetween is improved, high-power radio frequency power can be withstood, the service life of the equipment is prolonged, and the quality of the film deposition products is improved.

To solve the above technical problems, the present application is configured as follows:

A first aspect of the present application provides a film deposition carrier for a film deposition apparatus, the film deposition apparatus further comprising a lifting heating plate. The film deposition carrier includes a frame and a tray, the tray being fixedly mounted on the frame, characterized in that the frame includes a plurality of ribs arranged in a criss-cross pattern and conductive wrapping sheets; at least one conductive wrapping sheet is provided at the bottom of any one or more of the ribs; after the lifting heating plate rises to a predetermined position, the bottom of the conductive wrapping sheet is in conductive contact with the upper surface of the lifting heating plate.

In addition, the film deposition carrier according to the present application may further have the following additional technical features:
In some of these embodiments, the conductive wrapping sheet is U-shaped, wraps around a surface of the rib with an opening facing upward, and is fixedly connected to the rib.

In some of these embodiments, the conductive wrapping sheet is L-shaped ; the horizontal portion of the L-shaped structure is wrapped on the lower surface of the rib, and the vertical portion of the L-shaped structure is wrapped on the side surface of the rib and fixedly connected to the rib.

In some of these embodiments, a slotted hole is provided in a side wall of the conductive wrapping sheet, and the slotted hole is a vertically arranged elongated hole; the conductive wrapping sheet and the rib are adjustably locked and connected through the slotted hole.

In some of these embodiments, the adjustable locking connection is specifically: a bolt is disposed in the slotted hole, and the bolt is threadedly fastened to a threaded hole formed in the rib; the installation position of the conductive wrapping sheet relative to the rib is adjusted up and down by sagging the locking position between the slotted hole and the bolt.

In some of these embodiments, the number of conductive wrapping sheets provided on a single rib is 1 to 20.

In some of these embodiments, the conductive wrapping sheet is an aluminum sheet, the thickness of the aluminum sheet is 0.1 mm to 1 mm; the sag of the aluminum sheet relative to the lower surface of the rib is 0 to 2 mm.

In some of these embodiments, the conductive wrapping sheet includes a stainless steel inner strip and a conductive layer disposed on the surface of the stainless steel inner strip.

In some of these embodiments, the conductive wrapping sheet is made of metal.

An embodiment of the present application further provides a film deposition apparatus, which includes the film deposition carrier as described above.

A second aspect of the embodiments of the present application further provides a film deposition carrier for a film deposition apparatus, including a carrier and a lifting heating plate. The carrier includes a frame and a tray, the tray is fixedly mounted on the frame, the frame includes a plurality of ribs arranged in a criss-cross pattern and conductive strips, and at least one conductive strip is arranged between any two of the ribs;
Two ends of the conductive strip are fixedly connected to the corresponding ribs; the middle portion of the conductive strip sags, and comes into contact with the upper surface of the lifting heating plate after the lifting heating plate rises to a predetermined position.

In addition, the film deposition carrier according to the present application may further have the following additional technical features:
In some of these embodiments, the natural sag of the middle portion of the conductive strip specifically means that the distance between the lowest point of the conductive strip and the lower surface of the rib is 0.5 mm to 5 mm.

In some of these embodiments, the conductive strip is an elongated flexible bar structure.

In some of these embodiments, the conductive strip includes fixing portions at both ends and a sagging portion in the middle, and the sagging portion is partially or entirely located below the ribs.

In some of these embodiments, the conductive strip includes a stainless steel inner strip and a conductive coating disposed on the surface of the stainless steel inner strip.

In some of these embodiments, the conductive strip is made of conductive metal.

In some of these embodiments, the thickness of the conductive strip is 0.1 mm to 1 mm.

In some of these embodiments, both ends of the conductive strip are fixedly connected to the corresponding ribs through locking corner brackets or bolts.

In some of these embodiments, the number of the conductive strips disposed between two adjacent ribs is 1 to 20.

An embodiment of the present application further provides a film deposition apparatus, which includes the film deposition carrier as described above.

Compared with the prior Art, the present invention has at least the following beneficial effects:
In the embodiment of the present application, the provided film deposition carrier achieves good contact between the carrier and the lifting heating plate by providing conductive wrapping sheets, improving the electrical conductivity therebetween, enabling the structure to withstand high-power radio frequency power feed-in, and reducing the risk of discharge between the carrier frame and the lifting heating plate, thereby avoiding damage to the carbon fiber carrier and the lifting heating plate caused by a large amount of heat generated instantaneously by the discharge arc, prolonging the service life of the carrier and the lifting heating plate, and the quality of the film deposition products is improved at the same time.

In the embodiment of the present application, the provided film deposition carrier achieves good contact between the carrier and the lifting heating plate by providing conductive strips, improving the electrical conductivity therebetween, high-power radio frequency power supply can be withstood, and it less prone to generate discharge between the carrier frame and the heating plate, thereby avoiding damage to the carbon fiber carrier and the lifting heating plate caused by a large amount of heat generated instantaneously by the discharge arc, prolonging the service life of the carrier and the lifting heating plate, and the quality of the film deposition products is improved at the same time.

In the embodiment of the present application, the conductive wrapping sheets provided on the film deposition carrier have a vertical adjustment function, which can adapt to various film deposition working conditions and ensure good contact between the carrier and the lifting heating plate.

The film deposition apparatus of the present application includes the film deposition carrier described above, and thus has at least all the features and advantages of the above-mentioned film deposition carrier, which will not be repeated herein. Additional aspects and advantages of the present application will be set forth in part in the description that follows, and in part will become apparent from the description, or be learned by the practice of the present invention.

### BRIEF DESCRIPTION OF THE DRAWINGS

Fig. 1 is a schematic top view of the film deposition carrier disclosed in the embodiment of the present application;
Fig. 2 is a schematic side view of the assembly structure of the aluminum sheet disclosed in the embodiment of the present application;
Fig. 3 is a longitudinal sectional view of the assembly structure of the U-shaped conductive wrapping sheet and the rib disclosed in the embodiment of the present application;
Fig. 4 is a longitudinal sectional view of the assembly structure of the L-shaped conductive wrapping sheet and the rib disclosed in the embodiment of the present application;
Fig. 5 is a schematic top view of the film deposition carrier disclosed in the embodiment of the present application;
Fig. 6 is a schematic side view of the film deposition carrier (where the conductive strip is disposed) disclosed in the embodiment of the present application;
Fig. 7 is a schematic isometric view of the film deposition carrier (where the conductive strip is disposed) disclosed in the embodiment of the present application;
Fig. 8 is a schematic view of the structure of the profiled conductive strip disclosed in the embodiment of the present application;
Fig. 9 is a schematic view of the assembly structure of the profiled conductive strip disclosed in the embodiment of the present application; wherein, (a) is a bottom view, and (b) is a schematic isometric view.

Brief Description of Reference Numerals:
1 - guide rail bar; 2 - rib; 3 - conductive wrapping sheet; 4 - bolt; 5 - slotted hole;
10 - frame rib; 20 - conductive strip; 30 - locking corner bracket;
21 - conductive strip fixing portion; 22 - conductive strip sagging portion; 23 - mounting threaded hole.

### DETAILED DESCRIPTION

The technical solutions in the embodiments of the present application will be clearly and completely described below with reference to the accompanying drawings in the embodiments of the present application. Obviously, the described embodiments are part of the embodiments of the present application, rather than all of the embodiments. Based on the embodiments in the present application, all other embodiments obtained by those of ordinary skill in the art without creative work shall fall within the protection scope of the present application.

The embodiments of the present application will be described in detail below through specific embodiments and their application scenarios with reference to the accompanying drawings.

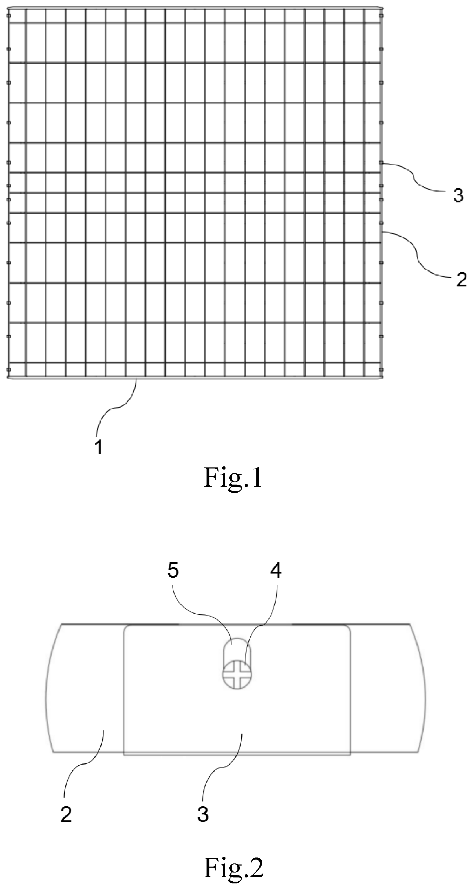

Please refer to Fig. 1. In some embodiments of the present application, a film deposition carrier is provided, which can be applied to film deposition equipment. For example, in the preparation process of solar cells, a process of film deposition the cells is involved. During the film deposition process, a lifting heating plate is required to lift the carrier containing the silicon wafers to a suitable position before film deposition. In the lifted state, the upper surface of the lifting heating plate comes into contact with the lower surface of the carrier. The film deposition carrier can achieve good contact between the lifting heating plate and the carrier, thereby solving the problems in the prior art of poor electrical conductivity and susceptibility to arc discharge due to gaps therebetween, which affect the film deposition quality and the service life of the lifting heating plate and the carrier. In addition, the film deposition carrier can also be used in other equipment or for other types of conductive contact requirements, and the embodiments of the present application impose no specific restrictions on the specific application scenarios and working conditions of the film deposition carrier.

Specifically, the film deposition carrier includes: a carrier and a conductive wrapping sheet 3. The carrier includes a frame and a tray, and the frame and the tray are fixed together by screws and locking corner brackets. The frame is made of carbon fiber, and includes a plurality of carbon fiber ribs 2 arranged in a criss-cross pattern and two transverse guide rail bars 1 (transverse refers to the transverse direction shown in Fig. 1). The lower surfaces of the ribs 2 and the guide rail bars 1 are both planar structures.

Wherein, the guide rail bars 1 may be ribs on both sides of the frame along the transport direction of the conveyor rollers, used for carrying the carrier; a plurality of ribs parallel to the two guide rail bars 1 are arranged between the two guide rail bars 1, and a plurality of ribs parallel to each other and perpendicular to the two guide rail bars are also disposed; wherein, conductive wrapping sheets 3 are disposed on the two vertical ribs 2 at both ends of the guide rail bars, and the conductive wrapping sheets 3 are configured to be in contact with the lifting heating plate (also referred to as the lifting heating plate) provided on the lifting frame inside the process chamber.

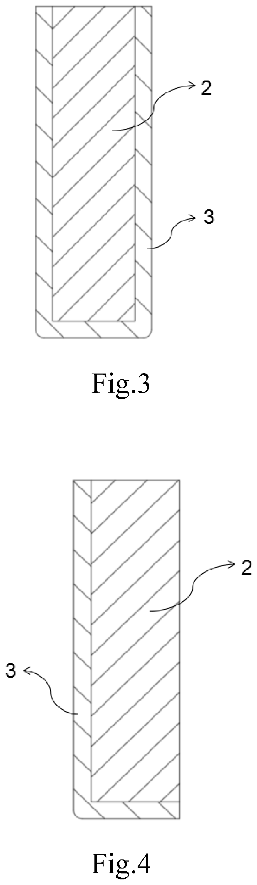

In some embodiments of the present application, the conductive wrapping sheet 3 is of a U-shaped structure and is sleeved on the outer surface of the rib 2 with its opening facing upward. As shown in Fig. 2 and Fig. 3. An slotted hole 5 is provided on the side wall of the U-shaped conductive wrapping sheet 3, and the slotted hole 5 is a vertically arranged oval or elongated hole. The bolt 4 is connected to the corresponding rib through the slotted hole 5, and the conductive wrapping sheet 3 is fixed by tightening the bolt. The bottom wall of the U-shaped conductive wrapping sheet 3 is in contact with the lifting heating plate for lifting; when the contact between the two is poor and needs to be adjusted, the locking position of the bolt 4 and the slotted hole 5 is adjusted by loosening the bolt 4. That is, the bolt 4 is loosened and the conductive wrapping sheet 3 is moved up and down to a proper position, and then the bolt 4 is tightened again to fix the conductive wrapping sheet 3, so that the position of the bottom wall of the conductive wrapping sheet 3 is suitable for good contact with the lifting heating plate. Due to the arrangement of the conductive wrapping sheet 3 in the present application, the lifting heating plate first contacts the conductive wrapping sheet when being lifted. The electrical conductivity of the conductive wrapping sheet is higher than that of the carbon fiber rib, thereby reducing the poor conduction caused by gaps between the carrier and the lifting heating plate, further mitigating arc discharge between the carrier and the lifting heating plate during plasma ignition, and improving the quality of the film deposition products as well as the service life of the lifting heating plate (i.e., the lifting heating plate) and the carrier.

Optionally, the conductive wrapping sheet 3 may be an elongated U-shaped structure with a length matching that of a single rib, or a short bar-shaped U-shaped structure. When the conductive wrapping sheet 3 is a short bar-shaped U-shaped structure, one or more short bar-shaped conductive wrapping sheets are arranged on one rib; specifically, the number of conductive wrapping sheets 3 disposed on a single rib on each side is 1 to 20, and the number can be increased or decreased according to actual requirements.

In the above embodiment, the conductive wrapping sheet 3 is an aluminum sheet with a thickness ranging from 0.1 mm to 1 mm. The aluminum sheet can be adjusted via the slotted hole such that it has a sag of 0 mm to 2 mm relative to the lower surface of the rib.

In other embodiments of the present application, the arrangement position of the conductive wrapping sheet 3 is not limited to the two vertical ribs at both ends of the carrier as shown in Fig. 1, but may also be any position of any rib of the carrier frame. The number can be increased as required, or all ribs can be wrapped with conductive wrapping sheets.

In some embodiments of the present application, the material of the conductive wrapping sheet 3 is not limited to aluminum, but can also be any other conductive material, such as copper, iron, etc., as long as its electrical conductivity is better than that of carbon fiber, so that arc discharge can be better reduced or eliminated.

Optionally, the conductive wrapping sheet may be made of other conductive materials, and a conductive layer is provided on the surface thereof, which may be formed by spraying or film deposition.

In some embodiments of the present application, the conductive wrapping sheet 3 may be formed in the aforementioned U-shape or L-shape, as shown in Fig. 4. Both side walls of the U-shaped conductive wrapping sheet 3 are locked with bolts. The L-shaped conductive wrapping sheet is unilaterally locked to the side surface of the rib, and the bottom is flush with the bottom of the rib or spaced apart therefrom by a certain distance, and sags slightly under gravity. The gap between the carrier rib and the lifting heating plate can be better bridged by the conductive wrapping sheet to achieve good contact.

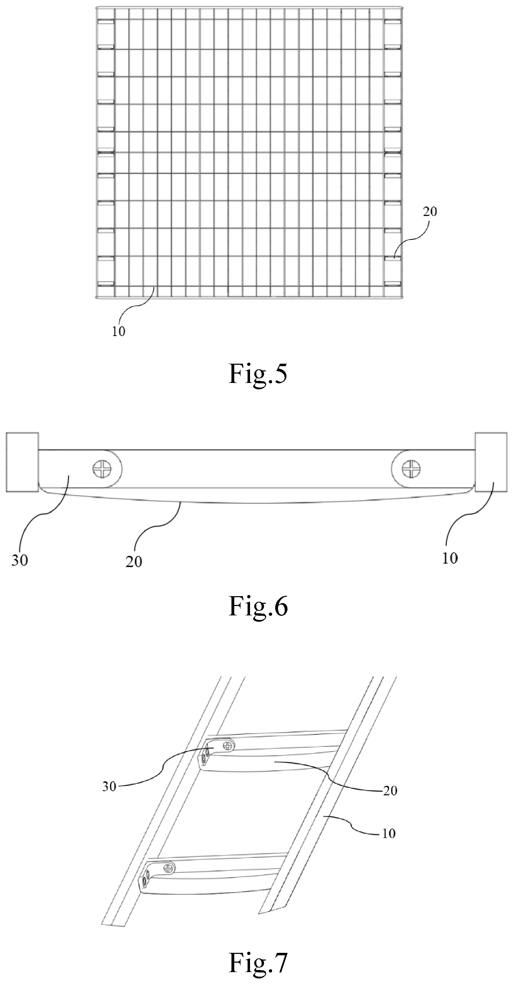

As another specific embodiment of the present application, refer to Fig. 5. In some embodiments, a film deposition carrier is provided, which is applicable to film deposition equipment. For example, the preparation process of solar cells involves a film deposition process for the cells. During film deposition, the carrier carrying silicon wafers is lifted to a proper position by a liftable lifting heating plate before film deposition. In the lifted state, the upper surface of the lifting heating plate is in contact with the lower surface of the carrier. The film deposition carrier can achieve good contact between the lifting heating plate (also referred to as the lifting heating plate) and the carrier, and solves the problems in the prior art that gaps therebetween result in poor electrical conductivity and prone to arc discharge, thereby affecting the film deposition quality and the service life of the lifting heating plate and the carrier. In addition, the film deposition carrier can also be used in other equipment or for other types of conductive contact requirements, and the embodiments of the present application do not specifically limit the specific application scenarios and working conditions of the film deposition carrier.

Specifically, the film deposition carrier includes a carrier and a conductive strip 20. The carrier includes a frame and a tray, and the frame and the tray are fixed together by screws and corner brackets. The frame is made of carbon fiber and includes a plurality of carbon fiber ribs 10 arranged in a criss-cross pattern, whose lower surfaces are all planar structures.

Wherein, the conductive strip 20 is an elongated bar structure, installed between two ribs on the inner side of the frame, specifically, the conductive strip is added between the first and second ribs on the left and right sides of the frame. Locking corner brackets 30 are used to fix the two ends of the conductive strip 20 to the corresponding ribs. The length of the conductive strip 20 is greater than the distance between the two ribs, so that the middle portion of the conductive strip 20 sags, thereby facilitating good contact with the upper surface of the liftable lifting heating plate located below.

In some embodiments of the present application, the lowest point of the conductive strip 20 extends 0.5 mm to 5 mm below the lower surface of the frame rib.

In some embodiments of the present application, the conductive strip 20 may be made of aluminum-coated stainless steel. The aluminum provides good electrical conductivity and corrosion resistance, while stainless steel has good elasticity and flexibility. Therefore, when the lifting heating plate under the carrier is lifted, the conductive strip 20 comes into contact with the lifting heating plate. Due to its certain elasticity and flexibility of the conductive strip, it facilitates surface contact with the lifting heating plate, which greatly increases the contact area between the carrier and the lifting heating plate, thereby improving the electrical conductivity between the carrier and the lifting heating plate; when film deposition is performed using a high-power VHF power supply, no arc discharge will occur between the carrier and the lifting heating plate, thereby improving the quality of the product and the service life of both the lifting heating plate and the carrier.

In some embodiments of the present application, the conductive strip 20 has a thickness of 0.1 mm to 1 mm.

Optionally, the disposition position of the conductive strip 20 is not limited to the ribs shown in Fig. 5, and a plurality of conductive strips 20 may be disposed between any two adjacent ribs. The number of conductive strips disposed between two adjacent ribs is 1 to 20.

In some of the above embodiments, referring to Fig. 6 and Fig. 7, the locking corner bracket 30 has an L-shaped structure, including two mutually perpendicular right-angle plates fixedly connected at their ends; one of the right-angle plates (referred to as the first right-angle plate) is fixed to the rib extending in the same direction as the conductive strip by means of bolts; the other right-angle plate (referred to as the second right-angle plate) is connected to the rib provided at the end of the conductive strip (i.e., the rib perpendicular to the direction of the conductive strip). The specific connection manner is that a bolt passes through the end of the conductive strip and is threadedly connected to the rib, thereby fixing the end of the conductive strip. Both ends of the conductive strip are fixed by the locking corner bracket as described above.

Optionally, the number of bolts on the first right-angle plate is one, and the number of bolts on the second right-angle plate for fixing the end of the conductive strip is two.

In some embodiments of the present application, the two ends of the conductive strip 20 are not limited to being fixed to the corresponding ribs by using the locking corner brackets 30, and may also be directly fixed by bolts.

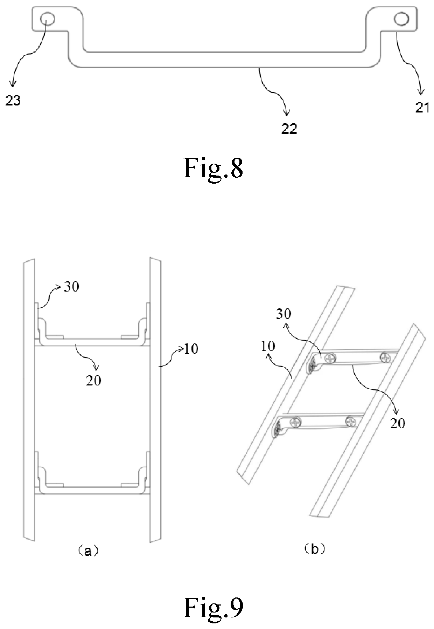

In other embodiments of the present application, the conductive strip 20 is a profiled conductive strip. Referring to Fig. 8, the conductive strip 20 includes a conductive strip fixing portion 21 and a conductive strip sagging portion 22. The profiled conductive strip has two conductive strip fixing portions 21 horizontally disposed at both ends of the conductive strip sagging portion 22; the conductive strip sagging portion 22 is also horizontally disposed and located below the two conductive strip fixing portions 21. A mounting threaded hole 23 is provided on the conductive strip fixing portion 21, and the conductive strip fixing portion 21 is rotatably connected to the corresponding rib through the mounting threaded hole 23 and the locking corner bracket 30. The assembly structure of the profiled conductive strip is shown in Fig. 9 (a) and Fig. 9 (b). The locking corner bracket 30 is arranged to intersect with the conductive strip 20, and the mounting threaded hole 23 is rotatable relative to the locking corner bracket 30 and the rib 10, so that the height of the conductive strip 20 is adjustable in real time, thereby adapting to installation conditions of different heights.

In this embodiment, when the width of the conductive strip sagging portion 22 is less than or equal to the width of the rib 10, the conductive strip sagging portion 22 is located entirely below the rib 10; when the width of the conductive strip sagging portion 22 is greater than the width of the rib 10, the conductive strip sagging portion 22 is partially located below the rib 10. The above arrangement facilitates surface contact between the profiled conductive strip and the lifting heating plate. The rib 10 presses the conductive strip sagging portion 22 of the profiled conductive strip onto the upper surface of the lifting heating plate, increasing the contact area between the carrier and the lifting heating plate, thereby improving the electrical conductivity between the carrier and the lifting heating plate.

Optionally, the material of the conductive strip is not limited to aluminum-coated stainless steel sheet, but can also be other metal materials.

During operation, due to the arrangement of the conductive strip 20 in the present application, the lifting heating plate first contacts the conductive strip 20 when being lifted. The electrical conductivity of the conductive strip 20 is better than that of the carbon fiber rib, and the higher the lifting heating plate is lifted, the larger the contact area between the conductive strip and the lifting heating plate is, and the better the electrical conductivity is. This reduces poor conductivity caused by gaps between the carrier and the lifting heating plate, mitigates arcing discharge between the carrier and the lifting heating plate during plasma ignition, and improves the quality of the film deposition products as well as the service life of the lifting heating plate and the carrier.

It should be noted that the specific structures and working principles of the temperature sensor, controller, etc. can all refer to the prior art, which are not limited in the present embodiment and will not be described in detail here.

Parts not described in detail in the present invention are known to those skilled in the art.

The embodiments of the present application have been described above with reference to the accompanying drawings. However, the present application is not limited to the specific embodiments described above. The foregoing specific embodiments are merely illustrative and not restrictive. Inspired by the present application, those skilled in the art may devise numerous modifications without departing from the spirit of the present application and the scope protected by the appended claims, all of which fall within the scope of protection of the present application.

## Claims

1. A film deposition carrier for a film deposition apparatus, the film deposition apparatus further comprising a lifting heating plate; the film deposition carrier comprises a frame and a tray, the tray being fixedly mounted on the frame, wherein the frame comprises a plurality of ribs arranged in a criss-cross pattern and conductive wrapping sheets; at least one conductive wrapping sheet is provided at the bottom of any one or more of the ribs; after the lifting heating plate rises to a predetermined position, the bottom of the conductive wrapping sheet is in conductive contact with the upper surface of the lifting heating plate.

2. The film deposition carrier according to claim 1, wherein the conductive wrapping sheet is U-shaped, wraps around a surface of said rib with an opening facing upward, and is fixedly connected to the rib.

3. The film deposition carrier according to claim 1, wherein the conductive wrapping sheet is L-shaped; the horizontal portion of the L-shaped structure is wrapped on the lower surface of the rib, and the vertical portion of the L-shaped structure is wrapped on the side surface of the rib, and fixedly connected to the rib.

4. The film deposition carrier according to claim 1, wherein a slotted hole is provided in a side wall of the conductive wrapping sheet, the slotted hole being a vertically arranged elongated hole; the conductive wrapping sheet and the rib are adjustably locked and connected via the slotted hole.

5. The film deposition carrier according to claim 4, wherein the adjustable locking connection is specifically: a bolt is disposed in the slotted hole, and the bolt is threadedly fastened to a threaded hole formed in the rib; the installation position of the conductive wrapping sheet relative to the rib is adjusted up and down by sagging the locking position between the slotted hole and the bolt.

6. The film deposition carrier according to claim 1, wherein the number of conductive wrapping sheets provided on a single rib is 1 to 20.

7. The film deposition carrier according to any one of claims 1 to 3, wherein the conductive wrapping sheet is an aluminum sheet with a thickness of 0.1 mm to 1 mm; the sag of the aluminum sheet relative to the lower surface of the rib is 0 to 2 mm.

8. The film deposition carrier according to claim 1, wherein the conductive wrapping sheet comprises a stainless steel inner strip and a conductive layer disposed on the surface of the stainless steel inner strip.

9. The film deposition carrier according to claim 1, wherein the conductive wrapping sheet is made of metal.

10. A film deposition carrier for a film deposition apparatus, the film deposition apparatus further comprising a lifting heating plate; the film deposition carrier comprises a frame and a tray, the tray being fixedly mounted on the frame, wherein the frame comprises a plurality of ribs arranged in a criss-cross pattern and conductive strips; at least one conductive strip is arranged between any two of the ribs; two ends of the conductive strip are fixedly connected to the corresponding ribs; the middle portion of the conductive strip sags and comes into contact with the upper surface of the lifting heating plate after the lifting heating plate rises to a predetermined position.

11. The film deposition carrier according to claim 10, wherein the middle portion of the conductive strip sags such that the distance between the lowest point of the conductive strip and the lower surface of the rib is 0.5 mm to 5 mm.

12. The film deposition carrier according to claim 10, wherein the conductive strip is an elongated flexible bar structure.

13. The film deposition carrier according to claim 10, wherein the conductive strip comprises fixing portion at both ends and a sagging portion in the middle, and the sagging portion is partially or entirely located below the ribs.

14. The film deposition carrier according to claim 10, wherein the conductive strip comprises a stainless steel inner strip and a conductive layer disposed on the surface of the stainless steel inner strip.

15. The film deposition carrier according to claim 10, wherein the conductive strip is made of metal.

16. The film deposition carrier according to claim 10, wherein the conductive strip has a thickness of 0.1 mm to 1 mm.

17. The film deposition carrier according to claim 10, wherein both ends of the conductive strip are fixedly connected to the corresponding ribs via locking corner brackets or bolts.

18. The film deposition carrier according to claim 10, wherein the number of the conductive strips disposed between two adjacent ribs is 1 to 20.

19. A film deposition apparatus, wherein comprising the film deposition carrier according to claim 1.

20. A film deposition apparatus, wherein comprising the film deposition carrier according to claim 10.
